# EUROPÄISCHE PATENTSCHRIFT

(11) **EP 3 877 564 B1**
(45) Veröffentlichungstag und Bekanntmachung des Hinweises auf die Patenterteilung: **31.08.2022**
(21) Anmeldenummer: 19778897.9
(22) Anmeldetag: 20.09.2019
(51) Int. Cl.: C23C 10/28, C23C 14/16, C23C 28/00, C23C 30/00, C25D 3/56, C25D 5/48, C25D 5/50

(54) **GEHÄRTETES BAUTEIL UMFASSEND EIN STAHLSUBSTRAT UND EINE KORROSIONSSCHUTZBESCHICHTUNG, ENTSPRECHENDES BAUTEIL ZUR HERSTELLUNG DES GEHÄRTETEN BAUTEILS SOWIE HERSTELLVERFAHREN UND VERWENDUNG**
HARDENED COMPONENT, COMPRISING A STEEL SUBSTRATE AND AN ANTI-CORROSION COATING, CORRESPONDING COMPONENT FOR PRODUCING THE HARDENED COMPONENT, PRODUCTION METHOD, AND USE
ÉLÉMENT STRUCTURAL TREMPÉ COMPRENANT UN SUBSTRAT EN ACIER ET UN REVÊTEMENT ANTICORROSION, ÉLÉMENT STRUCTURAL CORRESPONDANT POUR LA RÉALISATION DE L'ÉLÉMENT STRUCTURAL TREMPÉ AINSI QUE PROCÉDÉ DE FABRICATION ET UTILISATION

(30) Priorität: 09.11.2018 DE 102018128131
(43) Veröffentlichungstag der Anmeldung: 15.09.2021
(73) Patentinhaber: ThyssenKrupp Steel Europe AG, 47166 Duisburg (DE); thyssenkrupp AG, 45143 Essen (DE)
(72) Erfinder: BIENHOLZ, Stefan, 44795 Bochum (DE); STILLE, Sebastian, 44263 Dortmund (DE)
(74) Vertreter: ThyssenKrupp Steel Europe AG
(86) Internationale Anmeldenummer: PCT/EP2019/075307
(87) Internationale Veröffentlichungsnummer: WO 2020/094285

(56) Entgegenhaltungen:
- EP-A1- 2 848 709
- EP-A1- 3 084 032
- WO-A1-2007/074994
- DE-A1-102014 004 652
- DE-A1-102014 018 650
- US-A- 4 548 868

## Beschreibung

Die vorliegende Erfindung betrifft ein gehärtetes Bauteil umfassend ein Stahlsubstrat und eine Korrosionsschutzbeschichtung; die Korrosionsschutzbeschichtung umfasst Mangan, Eisen und Zink. Die Beschreibung betrifft zudem ein Bauteil zur Herstellung des erfindungsgemäßen gehärteten Bauteils; das Bauteil umfasst ein Stahlsubstrat und eine das Stahlsubstrat kontaktierende metallische Schicht.

Zudem betrifft die vorliegende Beschreibung ein Verfahren zum Herstellen eines erfindungsgemäßen Bauteils und ein Verfahren zum Herstellen eines erfindungsgemäßen gehärteten Bauteils.

Schließlich betrifft die Beschreibung auch die Verwendung eines erfindungsgemäßen Bauteils zum Herstellen eines erfindungsgemäßen gehärteten Bauteils.

Ein Bauteil liegt häufig in Form eines Stahlbleches und dabei insbesondere in Form eines PHS-Stahlbleches (presshärtendes Stahlblech) vor.

Ein erfindungsgemäßes gehärtetes Bauteil ist vorzugsweise ein Stahlformteil, welches aus einem entsprechenden presshärtenden Stahlblech hergestellt ist.

Zur Bezeichnung "presshärtendes Stahlblech" (bzw. "PHS-Stahlblech") sei auf das Dokument DE 10 2012 024 616 A1 verwiesen. Wie dort ausgeführt, lassen sich aus presshärtenden Stahlblechen gehärtete Bauteile mit extrem hoher Festigkeit fertigen, indem das Stahlblech über die Austenitisierungstemperatur erhitzt und durch Abkühlung während des Pressens ein im Wesentlichen rein martensitisches Gefüge erhalten wird.

Die vorliegende Beschreibung ist jedoch nicht auf den Einsatz von presshärtendem Stahlblech (als Bauteil) bzw. auf daraus hergestellte Stahlformteile (als gehärtetes Bauteil) beschränkt.

Im Rahmen der vorliegenden Beschreibung ist das Stahlsubstrat des Bauteils und des entsprechenden gehärteten Bauteils vorzugsweise ein Mangan-Bor-Stahl. Bei der Warmumformung solcher Mangan-Bor-Stähle kommen üblicherweise Korrosionsschutzbeschichtungen zum Einsatz, beispielsweise Al-Si-Beschichtungen, um ein Verzundern der Oberfläche zu verhindern. Solche Al-Si-Beschichtungen schützen durch ihre Barrierewirkung jedoch nur passiv vor Korrosion. Der Einsatz von aktiv schützenden Zn-Überzügen ist aufgrund des vergleichsweise niedrigen Schmelzpunkts des reinen Zinks von 419 °C nur eingeschränkt möglich. Es wird nämlich beobachtet, dass bei Umformung flüssiges Zink in den Grundwerkstoff (das Stahlsubstrat) eindringt und dort zu einer Rissbildung führt (sogenannte Flüssigmetallversprödung). Vereinzelt wird dieses Problem bereits umgangen, indem der Zn-Überzug durch eine höherschmelzende Legierung substituiert wird, sodass dies bei der Warmumformung nur zu einem ausreichend geringen Anteil in flüssiger Form vorliegt. Insoweit sei erneut auf das Dokument DE 10 2012 024 616 A1 verwiesen. Dort wird ein Stahlblech offenbart, insbesondere ein presshärtendes Stahlblech, mit einer Stahl-Substratschicht und einer Zink und Mangan enthaltenden Korrosionsschutzschicht. Die Korrosionsschutzschicht ist dabei galvanisch auf die Substratschicht aufgetragen und weist einen Mangananteil von wenigstens 5 Gew.-%, aber maximal 25 Gew.-% auf. Gemäß der Offenbarung sollte ein Mangananteil von 25 Gew.-% nicht überschritten werden.

WO 2015/090621 A1 offenbart Stahlbleche für die Warmumformung mit einer Korrosionsschutzbeschichtung, die auf Zink basiert, insbesondere werden Zn-Mn-Beschichtungen beschrieben mit einem Mn-Anteil von 19-30 Gew.-%

US 5,043,230 A offenbart Stahlbleche, die mit einer Mehrzahl von Schichten aus Zink-Mangan-Legierungen beschichtet sind; die Legierungsschicht, die der Stahloberfläche benachbart ist, hat dabei einen höheren Mangananteil als die Schicht oder Schichten, die von der Stahloberfläche weiter entfernt sind. US 5,043,230 A offenbart nicht die Warmumformung entsprechender Stahlbleche und somit auch nicht die Produkte einer solchen Warmumformung.

Das Dokument WO 2016/071399 A1 offenbart ein Verfahren zum Herstellen gehärteter Stahlblechbauteile, wobei auf ein Band aus einer abschreckhärtbaren Stahllegierung als Korrosionsschutzbeschichtung zumindest zwei Metallschichten nacheinander auf dem Stahlsubstrand abgeschieden werden. Dabei ist die eine Metallschicht eine Schicht aus Zink oder auf Basis von Zink und die andere eine Schicht aus einem Metall, das mit Zn oder Fe intermetallisch unedlere Phasen bildet und ein höheres Oxidationspotential hat als Zn, nämlich Ni, Cu, Co, Mn oder Mo, oder eine Schicht auf Basis dieser Metalle ist. Die Schicht aus Zink oder auf Basis von Zink wird gemäß WO 2016/071399 A1 elektrolytisch oder über ein Schmelztauchverfahren aufgebracht.

DE 10 2014 004 652 A1 offenbart ein Bauteil, insbesondere Strukturbauteil, für einen Kraftwagen, mit einem aus einem warmumformbaren Stahl gebildeten Grundkörper, welcher zumindest in einem Teilbereich mit einer Beschichtung versehen ist. Die Beschichtung kann dabei aus Zink-Mangan gebildet sein. Angaben zu Mengenanteilen von Zink und Mangan in der Beschichtung finden sich in dem Dokument nicht.

WO 2015/090621 A1 offenbart ein Stahlsubstrat, das mit einer korrosionswiderstandsfähigen Beschichtung mit hoher Schmelztemperatur versehen ist. Bei der Beschichtung kann es sich um eine Zn-Mn-Beschichtung mit einem Mn-Gehalt von ≥ 19 Gew.-% handeln. Der Mn-Gehalt in der Zn-Mn-Beschichtung kann im Bereich von 19 bis 30 Gew.-% liegen. Detaillierte Angaben zur Zusammensetzung oder zum Gefüge des Stahlsubstrats finden sich in WO 2015/090621 A1 nicht.

WO 2015/027972 A1 offenbart eine zinkbasierte Korrosionsschutzbeschichtung für Stahlbleche oder Stahlbänder, wobei die Korrosionsschutzbeschichtung ein im Schmelztauchverfahren aufgebrachter Überzug ist und neben einem Zinkanteil von mindestens 75 Gew.-% und gegebenenfalls vorhandenen und vermeidbaren Verunreinigungen 0,5 bis 15,0 Gew.-% Mangan und 0,1 bis 10,0 Gew.-% Aluminium enthält. Es wird offenbart, dass die Zugabe von Aluminium in Gehalten von 0,1 bis 10 Gew.-% notwendig ist, damit sich im Zuge der Erwärmung auf Austenitisierungstemperatur auf der Oberfläche der Beschichtung eine Aluminiumoxidschicht ausbildet.

Aus dem Stand der Technik sind somit bereits Korrosionsschutzbeschichtungen für Stahlbleche (Bauteile) und warmumgeformte Stahlbleche (gehärtete Bauteile) bekannt, welche Zink und Mangan enthalten. Die bereits bekannten Korrosionsschutzbeschichtungen, Bauteile bzw. gehärteten Bauteile sowie die Verfahren zu ihrer jeweiligen Herstellung erscheinen jedoch noch nicht optimal. So besteht Bedarf an einer Korrosionsschutzbeschichtung eines Bauteils, die während des Aufheizens eine dunkle Färbung besitzt oder annimmt, sodass im Ofen Strahlungsenergie besonders effizient aufgenommen werden und das Substrat somit besonders schnell auf eine Temperatur oberhalb von Ac3 aufgeheizt werden kann.

Hiermit korrespondiert der bestehende Bedarf an Bauteilen mit einer Korrosionsschutzbeschichtung, welche nach nur kurzer Ofenliegezeit pressgehärtet werden können, ohne dass dies einen Einfluss auf das angestrebte Gefüge nach dem Presshärten hat. Gleichzeitig wird angestrebt, bei Verwendung bestehender Öfen den Durchsatz zu erhöhen oder bei Konzeption bzw. Anschaffung neuer Öfen für einen gegebenen Durchsatz den zukünftigen Ofen kleiner auslegen zu können.

Darüber hinaus besteht ein Bedarf an Korrosionsschutzschichten, die einen aktiven Korrosionsschutz ermöglichen, wobei ein aktiver Korrosionsschutz vorzugsweise durch eine elektrochemische Potentialdifferenz zwischen Korrosionsschutzbeschichtung und Substrat von mindestens 150 mV gegeben ist.

Zudem besteht auch ein Bedarf an Korrosionsschutzbeschichtungen, Bauteilen bzw. gehärteten Bauteilen, bei der Werkzeug- und Ofenrollenanhaftungen unterdrückt bzw. vollständig vermieden werden. Wird ein Überzug flüssig, wie es mit Korrosionsbeschichtungen aus dem Stand der Technik häufig der Fall ist, bleibt immer ein Teil der Beschichtung an den Ofenrollen oder im Werkzeug haften, was die Standzeit des Equipments reduziert. Daher sind Korrosionsschutzbeschichtungen vorteilhaft, die außen fest bleiben.

Zudem sollten die mit dem jeweiligen vorstehend referierten Stand der Technik verbundenen Nachteile vorzugsweise überwunden oder zumindest abgeschwächt werden.

Die vorliegende Erfindung betrifft mit ihren Aspekten, die miteinander über eine gemeinsame technische Lehre verknüpft sind, einzelne oder sämtliche der vorstehend genannten Aufgabenstellungen bzw. Bedürfnisse.

Gemäß einem primären Aspekt der vorliegenden Erfindung, welcher ein gehärtetes Bauteil betrifft, werden zahlreiche der vorstehend angegebenen Aufgabenstellungen gelöst durch ein gehärtetes Bauteil, umfassend ein Stahlsubstrat und eine Korrosionsschutzbeschichtung, wobei die Korrosionsschutzbeschichtung eine das Stahlsubstrat kontaktierende erste Legierungsschicht, deren zwei Hauptbestandteile Eisen und Zink sind, und eine die erste Legierungsschicht kontaktierende zweite Legierungsschicht, deren zwei Hauptbestandteile Mangan und Zink sind, umfasst und wobei der Anteil der Gesamtmasse an Mangan in der Korrosionsschutzbeschichtung an der Gesamtmasse an Mangan und Zink in der Korrosionsschutzbeschichtung größer ist als 25 % und kleiner 40 % ist.

Weiterhin ausgestaltet ist ein erfindungsgemäßes gehärtetes Bauteil (wie vorstehend beschrieben), in der Korrosionsschutzbeschichtung weiter umfassend eine die zweite Legierungsschicht kontaktierende äußere Schicht umfassend Manganoxid, wobei vorzugsweise die Dicke der ersten Legierungsschicht größer oder gleich der Gesamtdicke der zweiten Legierungsschicht und der äußeren Schicht ist. Ein solches erfindungsgemäßes gehärtetes Bauteil umfasst somit in der Korrosionsschutzbeschichtung neben der ersten Legierungsschicht und der zweiten Legierungsschicht auch noch zumindest die äußere Schicht umfassend Manganoxid. Diese wird bei der Herstellung des gehärteten Bauteils regelmäßig durch Reaktion von Mangan (wie es insbesondere auch in der zweiten Legierungsschicht vorhanden ist) mit Sauerstoff, z. B. dem Sauerstoff der Umgebungsluft, gebildet. Eine solche äußere Schicht umfassend Manganoxid zeichnet sich dadurch aus, dass sie durch ihre dunkle Färbung in einem Ofen nur wenig Strahlung reflektiert. Demzufolge nimmt die Oberfläche mehr Strahlungsenergie auf und lässt sich schnell aufheizen. Entsprechende Vorteile betreffen auch insbesondere das erfindungsgemäße Herstellverfahren.

Die erste Legierungsschicht und die zweite Legierungsschicht sind, weil zur Herstellung des erfindungsgemäßen gehärteten Bauteils regelmäßig von einem beschriebenen Bauteil ausgegangen und ein erfindungsgemäßes Herstellverfahren durchgeführt wird, üblicherweise das Ergebnis einer Entmischung einer Ausgangslegierung, die als Hauptbestandteile Mangan und Zink umfasst; die erste Legierungsschicht enthält aufgrund von Diffusionsprozessen üblicherweise einen hohen Anteil an Eisen, welcher aus dem Stahlsubstrat stammt. Zu erfindungsgemäßen Bauteilen, Verfahren und Verwendungen siehe unten.

Die das Stahlsubstrat kontaktierende erste Legierungsschicht, deren zwei Hauptbestandteile Eisen und Zink sind, schützt das Substrat aktiv kathodisch. Die zweite Legierungsschicht, deren zwei Hauptbestandteile Mangan und Zink sind, besitzt einen Schmelzpunkt deutlich oberhalb der bei der Warmumformung üblicherweise eingesetzten Temperaturen. Hierdurch gibt es vorteilhafterweise weniger Werkzeug- und Ofenrollenanhaftungen. Es ist hierbei zu beachten, dass in der zweiten Legierungsschicht, deren zwei Hauptbestandteile Mangan und Zink sind, der Anteil der Gesamtmasse an Mangan deutlich höher ist als in der ersten Legierungsschicht. In der ersten Legierungsschicht sind nämlich die Hauptbestandteile Eisen und Zink, das heißt, dass sowohl der Anteil an Eisen als auch der Anteil an Zink in dieser ersten Legierungsschicht jeweils höher ist als der Anteil irgendeines anderen Metalls, einschließlich Mangan. In der zweiten Legierungsschicht hingegen sind Mangan und Zink die beiden Hauptbestandteile, das heißt, der Anteil an Mangan und der Anteil an Zink ist jeweils höher als der Anteil an weiteren Legierungsbestandteilen, einschließlich Eisen.

In der zweiten Legierungsschicht kann der Anteil an Eisen an der Gesamtmasse der zweiten Legierungsschicht bis zu 20 Gew.-% betragen. Lokal kann dabei in manchen Fällen der Anteil der Gesamtmasse an Eisen sogar höher sein als der Anteil der Gesamtmasse an Zink. Derartige lokale Besonderheiten sind in der Regel unproblematisch; für die Zwecke der vorliegenden Erfindung ist es jedoch erforderlich, dass in der zweiten Legierungsschicht insgesamt Mangan und Zink die zwei Hauptbestandteile sind.

Vorzugsweise sind in der zweiten Legierungsschicht Mangan und Zink die zwei Hauptbestandteile und die drei Hauptbestandteile Mangan, Zink und Eisen. Dies bedeutet, dass Mangan und Zink jeweils in einer größeren Menge in der zweiten Legierungsschicht insgesamt enthalten sind als Eisen, Eisen jedoch in einer größeren Menge enthalten ist als jeder weitere etwaig enthaltene Legierungsbestandteil. Wie vorstehend ausgeführt, sind lokale Konzentrationsschwankungen für die Bestimmung der Hauptbestandteile in der zweiten Legierungsschicht unbeachtlich, da es insoweit auf die Legierungsschicht insgesamt und auf die in ihr enthaltenen Gesamtmassen ankommt.

In einem bevorzugten erfindungsgemäßen gehärteten Bauteil ist die Dicke der ersten Legierungsschicht vorzugsweise größer oder gleich der Dicke der zweiten Legierungsschicht. Dies gilt vorzugsweise zumindest in 80 % der Gesamtfläche der Korrosionsschutzbeschichtung, besonders bevorzugt in zumindest 90 Gew.-% der Gesamtfläche der Korrosionsschutzbeschichtung. Auf diese Weise wird ein besonders effektiver Korrosionsschutz sichergestellt. Ausgehend von erfindungsgemäßen Bauteilen und unter Verwendung erfindungsgemäßer Herstellverfahren (siehe dazu im Detail unten) kann der Fachmann insbesondere über die Variation der Verweilzeit bei ausgewählten hohen Temperaturen die Dicke der Legierungsschichten in gewünschter Weise einstellen.

Erfindungsgemäße gehärtete Bauteile lassen sich besonders effizient und unter Vermeidung von bisher üblichen Nachteilen herstellen.

Bevorzugt ist ein erfindungsgemäßes gehärtetes Bauteil (vorzugsweise wie vorstehend als bevorzugt bezeichnet), wobei der Anteil der Gesamtmasse an Mangan in der Korrosionsschutzbeschichtung an der Gesamtmasse an Mangan und Zink in der Korrosionsschutzschichtung größer oder gleich 27 % ist, bevorzugt größer oder gleich 30 % ist. Es hat sich gezeigt, dass bei einem derart hohen Gesamtanteil an Mangan an der Gesamtmasse von Mangan und Zink in der Korrosionsschutzbeschichtung (umfassend die erste Legierungsschicht, die zweite Legierungsschicht und gegebenenfalls eine äußere Schicht umfassend Manganoxid) in überraschender Weise besonders klar sichergestellt ist, dass nur äußerst geringe Mengen an Zink beim Erhitzen abdampfen, Strahlungsenergie besonders effizient aufgenommen wird, die Ofenliegezeit vorteilhaft reduziert werden kann, ein besonders effizienter Korrosionsschutz erreicht werden kann und die mit einer Flüssigmetallversprödung einhergehenden nachteiligen Effekte nicht oder nur in reduziertem Umfang beobachtet werden.

Entsprechendes gilt für ein erfindungsgemäßes gehärtetes Bauteil (vorzugsweise wie vorstehend als bevorzugt bezeichnet), wobei der Anteil der Gesamtmasse an Mangan in der Korrosionsschutzbeschichtung an der Gesamtmasse an Mangan und Zink in der Korrosionsschutzbeschichtung kleiner 40 % ist, bevorzugt kleiner 35 % ist. Es hat sich gezeigt, dass bei Überschreiten eines Mangan-Anteils von 40 % (bezogen auf die Gesamtmasse an Mangan und Zink in der Korrosionsschutzbeschichtung insgesamt) die vorstehend diskutierten einzelnen Vorteile zum Teil nicht mehr reproduzierbar erreicht werden.

Weiterhin ausgestaltet ist ein erfindungsgemäßes gehärtetes Bauteil (vorzugsweise wie vorstehend als bevorzugt bezeichnet), wobei der Anteil der Gesamtmasse an Mangan in der Korrosionsschutzbeschichtung an der Gesamtmasse an Mangan und Zink in der Korrosionsschutzbeschichtung im Bereich von größer als 25 % bis 40 % liegt, bevorzugt im Bereich von größer als 25 % bis 35 %, besonders bevorzugt im Bereich von 27 % bis 35 %. In den besagten Konzentrationsbereichen zeigen sich die vorstehend genannten Vorteile besonders ausgeprägt.

Wie vorstehend bereits ausgeführt, enthalten im Einzelfall erfindungsgemäße gehärtete Bauteile in der zweiten Legierungsschicht, deren zwei Hauptbestandteile Mangan und Zink sind, Eisen in einer Menge von bis zu 20 Gew.-%, bezogen auf die zweite Legierungsschicht. Auf die obigen Ausführungen sei verwiesen.

Bevorzugt ist ein erfindungsgemäßes gehärtetes Bauteil, wobei die zweite Legierungsschicht bei einer Temperatur von 880 °C zumindest zu 70 Vol.-%, bevorzugt zumindest zu 80 Vol.-%, im festen Aggregatzustand vorliegt.

Der Fachmann kann diese Eigenschaft eines bevorzugten erfindungsgemäßen gehärteten Bauteils durch Variation der Anteile an Mangan und Zink sowie durch Variation der Parameter des Herstellverfahrens in üblicher Weise einstellen. Die Einstellung der bevorzugten Eigenschaft führt dazu, dass auch bei der genannten Temperatur von 880 °C lediglich ein kleiner Teil der zweiten Legierungsschicht schmelzflüssig ist, sodass eine signifikante Flüssigmetallversprödung unterbleibt. Entsprechende Vorteile betreffen selbstverständlich auch das erfindungsgemäße Verfahren zur Herstellung des erfindungsgemäßen gehärteten Bauteils, siehe dazu die Ausführungen weiter unten.

Vorzugsweise ist das Stahlsubstrat eines erfindungsgemäßen gehärteten Bauteils (vorzugsweise wie vorstehend als bevorzugt bezeichnet) ein Mangan-Bor-Stahl. Bevorzugt eingesetzt werden Stahlsubstrate, deren Zusammensetzung wie folgt definiert ist:
0,07 - 0,4 Gew.-% C, 1,0 - 2,5 Gew.-% Mn, 0,06 - 0,9 Gew.-% Si, bis zu 0,03 Gew.-% P, bis zu 0,01 Gew.-% S, bis zu 0,1 Gew.-% Al, bis zu 0,15 Gew.-% Ti, bis zu 0,6 Gew.-% Nb, bis zu 0,005 Gew.-% B, bis zu 0,5 Gew.-% Cr, bis zu 0,5 Gew.-% Mo, wobei die Summe der Gehalte an Cr und Mo höchstens 0,5 Gew.-% beträgt, Rest Eisen und unvermeidbare Verunreinigungen.

Besonders bevorzugt sind Stahlsubstrate, deren Zusammensetzung wie folgt definiert ist:
0,07 - 0,4 Gew.-% C, 1,0 - 2 Gew.-% Mn, 0,06 - 0,4 Gew.-% Si, bis zu 0,03 Gew.-% P, bis zu 0,01 Gew.-% S, bis zu 0,1 Gew.-% Al, bis zu 0,15 Gew.-% Ti, bis zu 0,6 Gew.-% Nb, bis zu 0,005 Gew.-% B, bis zu 0,5 Gew.-% Cr, bis zu 0,5 Gew.-% Mo, wobei die Summe der Gehalte an Cr und Mo höchstens 0,5 Gew.-% beträgt, Rest Eisen und unvermeidbare Verunreinigungen.

Und ganz besonders bevorzugt sind Stahlsubstrate, die wie folgt definiert sind:
0,07 - 0,4 Gew.-% C, 1,0 -1,5 Gew.-% Mn, 0,3 - 0,4 Gew.-% Si, bis zu 0,03 Gew.-% P, bis zu 0,01 Gew.-% S, bis zu 0,05 Gew.-% Al, bis zu 0,15 Gew.-% Ti, bis zu 0,6 Gew.-% Nb, bis zu 0,005 Gew.-% B, bis zu 0,5 Gew.-% Cr, bis zu 0,5 Gew.-% Mo, wobei die Summe der Gehalte an Cr und Mo höchstens 0,5 Gew.-% beträgt, Rest Eisen und unvermeidbare Verunreinigungen.

Der für das Stahlsubstrat verwendete Stahlwerkstoff kann dabei sowohl in Reinform wie auch in Kombination in Form von Schichten (3-5 Schichten, Bleche übereinander, die vorab durch einen Walzprozess zu einem Stahlband verbunden werden) oder gefügten Stahlblechen (z. B. Kombination von zwei Stahlbändern aneinander, die z. B. durch eine Laserschweißnaht zu einem Stahlband gefügt werden oder in Form von Platinen Tailored Blanks) Anwendung finden.

Die Dicke des Stahlsubstrats liegt vorzugsweise im Bereich von 0,6 mm bis 7 mm, bevorzugt im Bereich von 0,8 bis 4 mm und besonders bevorzugt im Bereich von 0,8 bis 3 mm.

Bevorzugt ist ein erfindungsgemäßes gehärtetes Bauteil (vorzugsweise wie vorstehend als bevorzugt bezeichnet), wobei das Stahlsubstrat ein Stahl mit martensitischem Gefüge, vorzugsweise ein Mangan-Bor-Stahl mit martensitischem Gefüge ist. Ausgehend von erfindungsgemäßen Bauteilen und unter Verwendung des erfindungsgemäßen Verfahrens (siehe dazu jeweils unten) lassen sich martensitische Gefüge erreichen, welche die vom Fachmann angestrebten Festigkeiten garantieren. Aufgrund der Korrosionsschutzbeschichtung besteht dabei ein hervorragender Korrosionsschutz.

Vorzugsweise ist ein erfindungsgemäßes gehärtetes Bauteil (vorzugsweise wie vorstehend als bevorzugt bezeichnet) ein pressgehärtetes Bauteil, vorzugsweise ein Bauteil eines Kraftfahrzeugs, bevorzugt ausgewählt aus der Gruppe bestehend aus Stoßfängerquerträger, Seitenaufprallträger, Säulen und Karosserieverstärkungen.

Gemäß einem weiteren Aspekt betrifft die Beschreibung ein Bauteil, insbesondere zur Herstellung eines erfindungsgemäßen gehärteten Bauteils, wie es in den Ansprüchen definiert und vorstehend diskutiert ist. Ein solches Bauteil umfasst ein Stahlsubstrat und eine das Stahlsubstrat kontaktierende ein- oder mehrlagige metallische Schicht, deren zwei Hauptbestandteile Zink und Mangan sind, wobei das Gefüge des Stahlsubstrats in ein martensitisches Gefüge umwandelbar ist, wobei in der das Stahlsubstrat kontaktierenden ein- oder mehrlagigen metallischen Schicht der Anteil der Gesamtmasse an Mangan an der Gesamtmasse an Mangan und Zink größer ist als 25 %, bevorzugt größer oder gleich 27 % ist, bevorzugt größer 30 % ist, und dabei besonders bevorzugt kleiner 40 % ist.

Es versteht sich, dass die vorstehend diskutierten erfindungsgemäßen gehärteten Bauteile herstellbar sind durch Behandeln eines derartigen Bauteils.

Die Bauteile besitzen somit in entsprechender Weise die vorstehend bereits diskutierten vorteilhaften Eigenschaften der entsprechenden gehärteten Bauteile, mutatis mutandis.

Bevorzugt ist ein Bauteil, wobei das Stahlsubstrat ein Stahl mit ferritisch-perlitischem Gefüge ist. Ein solcher Stahl ist bevorzugt ein Mangan-Bor-Stahl mit ferritisch-perlitischem Gefüge und besonders bevorzugt ein Mangan-Bor-Stahl mitferritisch-perlitischem Gefüge, welches durch thermische Härtungsbehandlung in ein martensitisches Gefüge umwandelbar ist. Entsprechende Stahlsorten sind dem Fachmann bekannt.

Besonders bevorzugt ist ein Bauteil (vorzugsweise ein Bauteil wie es vorstehend als bevorzugt bezeichnet ist), wobei in der das Stahlsubstrat kontaktierenden ein- oder mehrlagigen metallischen Schicht der Gesamtanteil an Mangan und Zink größer ist als 90 Gew.-%, bevorzugt größer ist als 95 Gew.-%, besonders bevorzugt größer ist als 99 Gew.-% und ganz besonders bevorzugt größer ist als 99,9 Gew.-%, und/oder der Anteil an Eisen kleiner ist als 10 Gew.-%, vorzugsweise kleiner ist als 2 Gew.-, und/oder kein Aluminium oder Aluminium in einer maximalen Menge von 0,05 Gew.-% enthalten ist.

Ebenso besonders bevorzugt ist ein Bauteil (vorzugsweise wie vorstehend als bevorzugt bezeichnet), wobei die das Stahlsubstrat kontaktierende ein- oder mehrlagige metallische Schicht eine einlagige Legierungsschicht ist, deren zwei Hauptbestandteile Zink und Mangan sind.

Der Fachmann entscheidet anhand mikroskopischer Untersuchungen, ob eine zu betrachtende Schicht ein- oder mehrlagig ist.

Der Fachmann kann beispielsweise durch Presshärten ein bevorzugtes Bauteil in ein bevorzugtes erfindungsgemäßes gehärtetes Bauteil überführen; zu ausgewählten Einzelheiten sei auf die nachfolgenden Ausführungen zu erfindungsgemäßen Verfahren verwiesen.

Es versteht sich, dass es zwar bei der Transformation des Bauteils in ein erfindungsgemäßes gehärtetes Bauteil zu einer geringfügigen Veränderung des Massenanteils an Zink kommen kann, beispielsweise, weil Zink verdampft oder in das Stahlsubstrat eindiffundiert, der Fachmann wird derartige Effekte jedoch bei der Konzeption des Bauteils unter Berücksichtigung der Verfahrensparameter bei der Überführung des Bauteils in das gehärtete Bauteil berücksichtigen.

Gemäß einem weiteren Aspekt betrifft die vorliegende Beschreibung ein Verfahren zum Herstellen eines Bauteils, mit folgenden Schritten:
- Herstellen oder Bereitstellen eines Stahlsubstrats, wobei das Gefüge des Stahlsubstrats in ein martensitisches Gefüge umwandelbar ist,
- Applizieren einer ein- oder mehrlagigen metallischen Schicht, deren zwei Hauptbestandteile Zink und Mangan sind, auf das Stahlsubstrat, wobei in der ein- oder mehrlagigen metallischen Schicht der Anteil der Gesamtmasse an Mangan an der Gesamtmasse an Mangan und Zink größer ist als 25 %, bevorzugt größer oder gleich 27 % ist, bevorzugt größer 30 % ist und dabei besonders bevorzugt kleiner 40 % ist.

Hinsichtlich des ausgewählten Anteils der Gesamtmasse an Mangan an der Gesamtmasse an Mangan und Zink in der metallischen Schicht des erfindungsgemäßen Bauteils gelten die vorstehenden Ausführungen zum Anteil der Gesamtmasse an Mangan in der Korrosionsschutzbeschichtung an der Gesamtmasse an Mangan und Zink in der Korrosionsschutzbeschichtung des erfindungsgemäß gehärteten Bauteils entsprechend.

Es ist ein erfindungsgemäßes Verfahren bevorzugt, wobei das Applizieren der ein- oder mehrlagigen metallischen Schicht mittels eines Verfahrens erfolgt, das ausgewählt ist aus der Gruppe bestehend aus elektrolytische Abscheidung, galvanische Abscheidung, physikalische Gasphasenabscheidung, Chemical Vapour Deposition, Tauchverfahren, Slurry-Verfahren, thermisches Spritzen und Kombinationen davon, bevorzugt elektrolytisch oder mittels physikalischer Gasphasenabscheidung erfolgt, und besonders bevorzugt mittels physikalischer Gasphasenabscheidung erfolgt.

Aus praktischen Gründen sind eine elektrolytische Abscheidung sowie eine physikalische Gasphasenabscheidung bevorzugt, wobei die physikalische Gasphasenabscheidung besonders vorteilhaft ist.

Ein weiterer Aspekt der vorliegenden Beschreibung betrifft ein Verfahren zum Herstellen eines erfindungsgemäßen gehärteten Bauteils. Ein solches erfindungsgemäßes Verfahren umfasst die folgenden Schritte:
- Bereitstellen eines Bauteils (wie in den ursprünglich eingereichten Ansprüchen definiert; vorzugsweise wie vorstehend als bevorzugt bezeichnet) oder Herstellen eines Bauteils gemäß einem beschriebenen Verfahren (wie in den ursprünglich eingereichten Ansprüchen definiert; vorzugsweise wie vorstehend als bevorzugt bezeichnet),
- Behandeln des bereitgestellten oder hergestellten Bauteils, sodass das gehärtete Bauteil resultiert.

Das Behandeln des bereitgestellten oder hergestellten Bauteils erfolgt dabei vorzugsweise in üblicher Weise, vorzugsweise thermisch, beispielsweise durch Warmumformung bzw. Presshärtung. Aufgrund der im erfindungsgemäßen Bauteil vorgesehenen, das Stahlsubstrat kontaktierenden, ein- oder mehrlagigen metallischen Schicht, deren zwei Hauptbestandteile Zink und Mangan sind, wird ein Verzundern der Oberfläche des Stahlsubstrats während der Warmumformung auch in Gegenwart von Sauerstoff weitgehend oder vollständig unterdrückt. Eine Flüssigmetallversprödung findet nur in geringem Umfang statt oder wird vermieden. Bei vorteilhafter Ausgestaltung bildet sich auf der Oberfläche eine Manganoxidschicht aus, sodass ein besonders hohes Maß an Strahlungsenergie aufgenommen werden kann, sodass das Bauteil insgesamt und insbesondere dessen Stahlsubstrat schneller auf eine Temperatur oberhalb Ac3 aufgeheizt werden kann. Hierdurch wiederum kann die Ofenliegezeit reduziert werden. Auf die vorstehenden Ausführungen sei verwiesen.

Bevorzugt ist ein Verfahren, wobei das bereitgestellte oder hergestellte Bauteil als Stahlsubstrat einen Stahl mit einem Gefüge umfasst, welches in ein martensitisches Gefüge umwandelbar ist, bevorzugt einen Stahl mit ferritisch-perlitischem Gefüge umfasst, besonders bevorzugt einen Mangan-Bor-Stahl mit ferritisch-perlitischem Gefüge, und das Behandeln umfasst: eine thermische Härtungsbehandlung, bei der das Gefüge in ein martensitisches Gefüge umgewandelt wird, und vorzugsweise eine mechanische Behandlung, bevorzugt ein mechanisches Umformen, vor, während und/oder nach der thermischen Härtungsbehandlung (vorzugsweise während).

Es versteht sich, dass die Eigenschaften des hergestellten gehärteten Bauteils von den Eigenschaften des eingesetzten, das heißt, bereitgestellten oder hergestellten Bauteils abhängen sowie von der Ausgestaltung der thermischen Härtungsbehandlung. Insoweit gelten die vorstehenden Ausführungen jeweils entsprechend. Dem Fachmann ist bekannt, wie er unter Verwendung eines bereitgestellten oder hergestellten Bauteils eine thermische Härtungsbehandlung und gegebenenfalls eine (vorzugsweise gleichzeitig) stattfindende mechanische Behandlung durchführen kann, um die gewünschten mechanischen Eigenschaften des herzustellenden gehärteten Bauteils zu erreichen.

Bevorzugt ist ein Verfahren, wobei das Behandeln zumindest die folgenden Schritte umfasst:
(i) ein thermisches Behandeln, bei dem das Gefüge des bereitgestellten oder hergestellten Bauteils so lange bei einer Temperatur oberhalb von Ac3 gehalten wird, bis das Gefüge vollständig oder teilweise in ein austenitisches Gefüge umgewandelt ist,
(ii) mechanisches Umformen des Bauteils, vor, während und/oder nach dem thermischen Behandeln,
(iii) Abkühlen des Bauteils von der Temperatur oberhalb von Ac3, während und/oder nach dem mechanischen Umformen, bevorzugt auf eine Temperatur von weniger als 100 °C, sodass ein martensitische Gefüge entsteht, vorzugsweise mit einer Abkühlrate > 20 K/s.

Vorzugsweise wird in Schritt (ii) das mechanische Umformen des Bauteils während der thermischen Behandlung durchgeführt.

Vorteilhafterweise kann das Behandeln in einem üblichen Ofen in Gegenwart von Luftsauerstoff erfolgen, ohne dass dies für den angestrebten Erfolg nachteilig ist.

Im Gegenteil: Vorzugsweise wird das Verfahren so durchgeführt, dass sich bei der thermischen Härtungsbehandlung durch Reaktion von in der metallischen Schicht des Bauteils vorhandenem Mangan mit Luftsauerstoff eine die zweite Legierungsschicht des fertigen gehärteten Bauteils kontaktierende äußere Schicht umfassend Manganoxid bildet. Diese äußere Schicht aus Manganoxid besitzt eine dunkle Farbe und erlaubt in der vorstehend bereits geschilderten Weise das effiziente Aufnehmen von Strahlungsenergie.

Die vorliegende Erfindung betrifft gemäß einem eng verwandten Aspekt auch ein Verfahren, vorzugsweise ein erfindungsgemäßes Verfahren, wie es vorstehend geschildert ist, zum Herstellen eines gehärteten Bauteils, vorzugsweise eines erfindungsgemäßen gehärteten Bauteils, mit folgenden Schritten:
- Herstellen oder Bereitstellen eines Stahlsubstrats,
- Applizieren einer ein- oder mehrlagigen metallischen Schicht, deren zwei Hauptbestandteile Zink und Mangan sind, auf das Stahlsubstrat, wobei in der ein- oder mehrlagigen metallischen Schicht der Anteil der Gesamtmasse an Mangan an der Gesamtmasse an Mangan und Zink größer ist als 25 %,
   bevorzugt größer oder gleich 27 % ist, bevorzugt größer 30 % ist und dabei kleiner 40 % ist,
sodass ein Bauteil resultiert, vorzugsweise ein Bauteil wie es vorstehend als bevorzugt bezeichnet ist,
wobei vorzugsweise in der das Stahlsubstrat kontaktierenden ein- oder mehrlagigen metallischen Schicht der Gesamtanteil an Mangan und Zink größer ist als 90 Gew.-%, bevorzugt größer ist als 95 Gew.-% und besonders bevorzugt größer ist als 99 Gew.-%,
wobei vorzugsweise das Applizieren der ein- oder mehrlagigen metallischen Schicht elektrolytisch oder mittels physikalischer Gasphasenabscheidung erfolgt, bevorzugt mittels physikalischer Gasphasenabscheidung,
wobei vorzugsweise die das Stahlsubstrat kontaktierende ein- oder mehrlagige metallische Schicht eine einlagige Legierungsschicht ist, deren zwei Hauptbestandteile Zink und Mangan sind,
wobei das Gefüge des Stahlsubstrats vorzugsweise in ein martensitisches Gefüge umwandelbar ist, bevorzugt ferritisch-perlitisch ist,
wobei vorzugsweise das Stahlsubstrat ein Mangan-Bor-Stahl mit ferritisch-perlitischem Gefüge ist,

- Behandeln des hergestellten Bauteils mit der ein- oder mehrlagigen metallischen Schicht, sodass das gehärtete Bauteil resultiert,
wobei das gehärtete Bauteil ein Stahlsubstrat und eine Korrosionsschutzbeschichtung umfasst, wobei die Korrosionsschutzbeschichtung
- eine das Stahlsubstrat kontaktierende erste Legierungsschicht, deren zwei Hauptbestandteile Eisen und Zink sind
und
- eine die erste Legierungsschicht kontaktierende zweite Legierungsschicht, deren zwei Hauptbestandteile Mangan und Zink sind
sowie vorzugsweise
- eine die zweite Schicht kontaktierende Schicht umfassend Manganoxid umfasst, wobei der Anteil der Gesamtmasse an Mangan in der Korrosionsschutzbeschichtung an der Gesamtmasse an Mangan und Zink in der Korrosionsschutzbeschichtung größer ist als 25 % und kleiner 40% ist, und
wobei vorzugsweise das hergestellte Bauteil als Stahlsubstrat einen Stahl mit ferritisch-perlitischem Gefüge umfasst, vorzugsweise einen Mangan-Bor-Stahl mit ferritisch-perlitischem Gefüge, und das Behandeln vorzugsweise eine thermische Härtungsbehandlung umfasst, bei der das Gefüge in ein martensitisches Gefüge umgewandelt wird.

Hinsichtlich bevorzugter Ausgestaltungen dieses erfindungsgemäßen Verfahrens sei auf die vorstehenden Ausführungen verwiesen, die jeweils entsprechend gelten. Das heißt, dass bevorzugte Ausgestaltungen eines erfindungsgemäßen gehärteten Bauteils, eines Bauteils umfassend ein Stahlsubstrat und eine das Stahlsubstrat kontaktierende ein- oder mehrlagige metallische Schicht sowie bevorzugte Ausgestaltungen eines Verfahrens zum Herstellen eines Bauteils bzw. zum Herstellen eines gehärteten Bauteils, jeweils entsprechend zutreffen.

Für sämtliche im Rahmen des vorliegenden Textes erläuterten Aspekte der Erfindung gilt, dass bevorzugte Ausgestaltungen, die zu einem dieser Aspekte dargelegt werden, mit den entsprechenden Änderungen auch für die anderen Aspekte zutreffen.

Die vorliegende Beschreibung betrifft auch die Verwendung eines Bauteils zum Herstellen eines erfindungsgemäßen gehärteten Bauteils. Die Ausführungen zu entsprechenden Verfahren gelten entsprechend.

Die Erfindung wird nachfolgend anhand von Beispielen näher erläutert.

### 1. Allgemeines Beispiel:

Auf einem Stahlblech aus Mangan-Bor-Stahl wird ein einlagiger Überzug aus einer ZnMn-Legierung aufgebracht, beispielsweise elektrolytisch oder in einem PVD-Prozess. Das Stahlsubstrat besitzt dabei ein ferritisch-perlitisches Gefüge, welches durch eine thermische Härtungsbehandlung in ein martensitisches Gefüge umwandelbar ist. Die Mangankonzentration im Überzug wird so gewählt, dass sich im Überzug hochschmelzende Phasen ausbilden können. Der Gesamtanteil an Mangan und Zink in der ZnMn-Legierung ist größer als 99,9 Gew.-%. Der Anteil an Eisen ist somit kleiner als 0,1 Gew.-%. Die Legierung enthält Aluminium in einer maximalen Menge von 0,05 Gew.-%, vorzugsweise enthält sie überhaupt kein Aluminium.

Der Anteil der Gesamtmasse an Mangan an der Gesamtmasse an Mangan und Zink in dem Überzug (der einlagigen metallischen Schicht) wird eingestellt, so dass er größer ist als 30 % und kleiner 40 %. Nach dem Applizieren des Überzugs wird das resultierende Bauteil einer thermischen Härtungsbehandlung unterzogen, nämlich einem Warmumformprozess, bei dem Temperaturen von 880 °C und höher erreicht werden, d. h. Temperaturen oberhalb der Austenitisierungstemperatur. Hierbei ist die Bildung von flüssigen Phasen im Überzug verringert und eine Flüssigmetallversprödung bei mechanischer Umformung ist soweit reduziert, dass die Entstehung von Substratrissen wesentlich eingedämmt ist. Während der thermischen Härtungsbehandlung kommt es zu einer Entmischung der ZnMn-Legierung des zuvor applizierten Überzugs. Zum einen entsteht eine das Stahlsubstrat kontaktierende erste Legierungsschicht, die aus einer FeZn-Legierung gebildet ist (die Hauptbestandteile der Schicht sind somit Eisen und Zink). Diese erste Legierungsschicht ist dazu geeignet, das Stahlsubstrat aktiv vor Korrosion zu schützen. Zum anderen bildet sich eine die erste Legierungsschicht kontaktierende, oberflächennahe (und damit vom Stahlsubstrat weiter entfernte) zweite Legierungsschicht aus einer MnZn-Legierung (die Hauptbestandteile der zweiten Legierungsschicht sind somit Mangan und Zink). Die MnZn-Schicht ist für den erfindungsgemäßen Erfolg besonders wichtig, da sie einen Schmelzpunkt besitzt, der deutlich höher ist als die bei der Warmumformung erreichte Temperatur. Hierdurch werden Werkzeug- und Ofenrollenanhaftungen zumindest weitgehend unterdrückt. Zudem wird durch die zweite Legierungsschicht (MnZn-Schicht) das Abdampfen von Zink unterdrückt, was von großer Bedeutung für die Standzeiten der verwendeten Öfen ist. Des Weiteren sorgt die hohe Mn-Konzentration an der Oberfläche dafür, dass bei der Wärmebehandlung kaum Eisen aus dem Stahlsubstrat an die Oberfläche diffundieren kann. Hierdurch wird die Rotrostbildung bei Korrosionsangriff reduziert.

### 2. Ausführungsbeispiele:

Mit einem PVD-Verfahren (Elektronenstrahlverdampfer) wurden ferritisch-perlitische Mangan-Bor-Stähle simultan mit Zink und Mangan beschichtet. Es wurden dabei ZnMn-Legierungsschichten (einlagige metallische Schicht, deren zwei Hauptbestandteile Zink und Mangan sind) mit einer Mangankonzentration zwischen 27 % und 39 % hergestellt. Die resultierenden Proben (als Beispiele für erfindungsgemäße Bauteile) wurden anschließend mit unterschiedlichen Haltedauern bei 880 °C warmumgeformt. Durch die thermische Behandlung entstand substratnah eine Schicht aus einer FeZn-Legierung und oberflächennah eine Schicht aus einer MnZn-Legierung (erste Legierungsschicht mit Hauptbestandteilen Eisen und Zink; zweite Legierungsschicht mit Hauptbestandteilen Mangan und Zink).

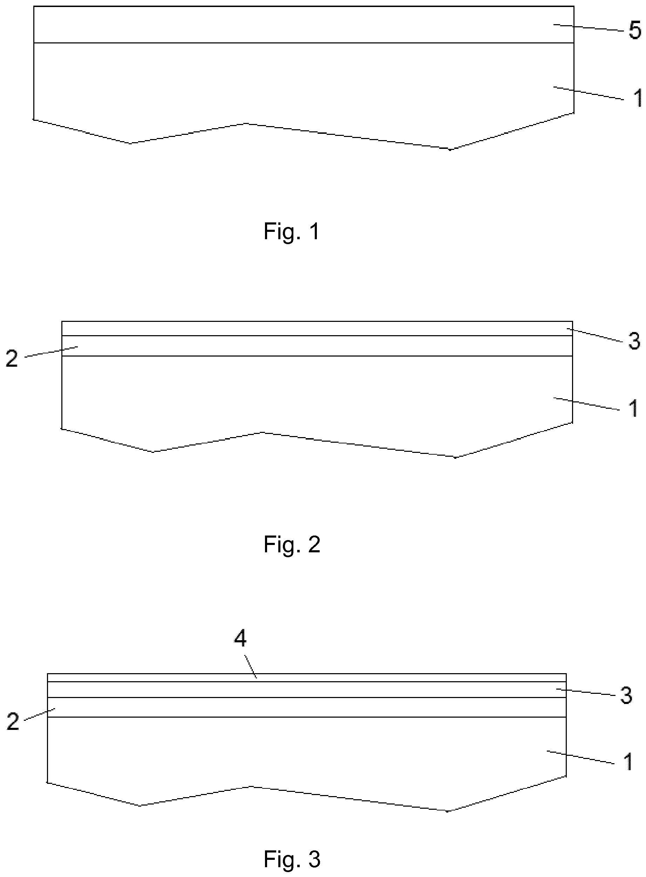

- Fig. 1: zeigt schematisch für ein erfindungsgemäßes Bauteil das Stahlsubstrat 1 und die das Stahlsubstrat kontaktierende einlagige metallische Schicht 5, deren zwei Hauptbestandteile Zink und Mangan sind.
- Fig. 2: zeigt schematisch ein erfindungsgemäß gehärtetes Bauteil nach der thermischen Behandlung (Warmumformung). Auf dem Stahlsubstrat 1 kontaktierend angeordnet ist eine erste Legierungsschicht 2, deren zwei Hauptbestandteile Eisen und Zink sind. Daran anliegend und die erste Legierungsschicht 2 kontaktierend ist eine zweite Legierungsschicht 3, deren zwei Hauptbestandteile Mangan und Zink sind.
- Fig. 3: zeigt schematisch ein erfindungsgemäßes Bauteil mit einer zusätzlichen oxidischen Schicht 4, die im Wesentlichen aus Manganoxid besteht. Das gehärtete Bauteil gemäß Fig. 3 umfasst somit auf dem Stahlsubstrat 1 neben der ersten Legierungsschicht 2 und der zweiten Legierungsschicht 3 eine die zweite Legierungsschicht kontaktierende äußere Schicht 4 umfassend Manganoxid.

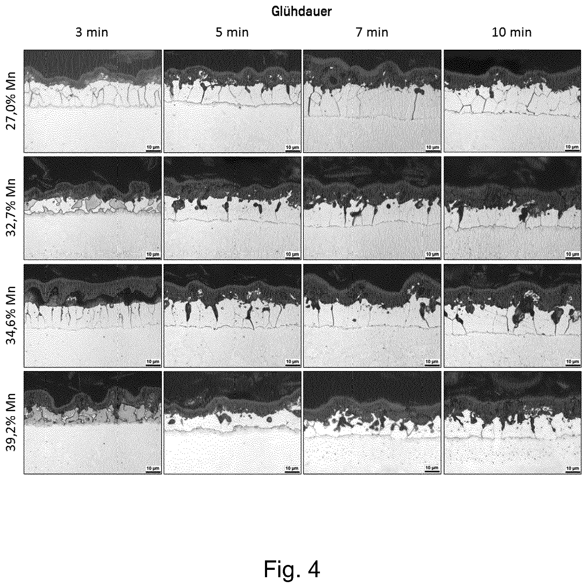

Die Ergebnisse der Untersuchungen sind in Fig. 4 dargestellt, welches eine Reihe mikroskopischer Schliffbilder zeigt.

Bereits nach 3 Min. Glühdauer hat sich auf dem Stahlsubstrat jeweils eine zweischichtige Korrosionsschutzbeschichtung (zweilagiger Aufbau) ausgebildet, die sich grundlegend vom Ausgangszustand (einlagige metallische Schicht mit Hauptbestandteilen Zink und Mangan; nicht in den Figuren dargestellt) unterscheidet. Die Dicke der vom Stahlsubstrat entfernteren der beiden Schichten (dies ist die zweite Legierungsschicht), welche als Hauptbestandteile Mangan und Zink enthält, steigt mit zunehmendem Mn-Gehalt der ursprünglich applizierten einlagigen metallischen Schicht aus Zink und Mangan an. Auf der zweiten Legierungsschicht bildet sich mit zunehmender Glühdauer fortschreitend eine in den Schliffbildern gemäß Figur 4 abgebildete Decklage (eine die zweite Legierungsschicht kontaktierende äußere Schicht), die oxidischer Natur ist und im Wesentlichen Manganoxid umfasst. Unmittelbar das Substrat kontaktierend und somit zwischen dem Substrat und der zweiten Legierungsschicht angeordnet ist eine erste Legierungsschicht, die als Hauptbestandteile Eisen und Zink aufweist. Die Decklage (äußere Schicht) ist sehr viel dunkler als die erste Legierungsschicht. Die äußere Schicht aus (im Wesentlichen) Manganoxid kann daher ein besonders hohes Maß an Strahlungsenergie aufnehmen, vgl. hierzu die obige Diskussion.

Punktuelle EDX-Messungen an den Querschliffen bestätigen, dass es bei allen untersuchten Proben ausgehend vom (noch nicht wärmebehandelten) Bauteil, welches ein Stahlsubstrat und eine das Stahlsubstrat kontaktierende einlagige metallische Schicht mit den Hauptbestandteilen Zink und Mangan umfasst, durch die Warmumformung zu einer Entmischung der ursprünglichen ZnMn-Legierung gekommen ist. Substratnah ist die gebildete Schicht an Mangan verarmt und an Eisen angereichert, sodass insgesamt eine metallische Doppelschicht aus FeZn (substratnah; erste Legierungsschicht) und MnZn (oberflächennah; zweite Legierungsschicht) entsteht. Die Rissbildung im Substrat ist im Vergleich mit Vergleichsexperimenten, bei denen anstelle einer MnZn-Schicht auf das Stahlsubstrat eine Schicht aus reinem Zink appliziert wurde, in allen Fällen signifikant vermindert. Die Entmischung von Zink und Mangan, das heißt die Ausbildung der Doppelschicht, nimmt mit steigender Glühdauer zu. Dies wurde über Stromdichte-Potential-Messungen ermittelt.

In eigenen Untersuchungen hat sich gezeigt, dass mit steigender Glühdauer (von 3 Min. über 5 Min und 7 Min. nach 10 Min.) das Ruhepotential der Schicht vom Zinkpotential in Richtung positiverer Werte verändert. Dies ist konsistent mit der Erhöhung des Mangangehaltes an der Oberfläche. Wenngleich die manganreiche Oberfläche keinen aktiven Korrosionsschutz bietet, kann sich die substratnähere FeZn-Schicht (erste Legierungsschicht) zugunsten des Substrates opfern.

## Patentansprüche

1. Gehärtetes Bauteil, umfassend ein Stahlsubstrat (1) und eine Korrosionsschutzbeschichtung (2,3,4), wobei die Korrosionsschutzbeschichtung (2,3,4)
- eine das Stahlsubstrat kontaktierende erste Legierungsschicht (2), deren zwei Hauptbestandteile Eisen und Zink sind,
- eine die erste Legierungsschicht (2) kontaktierende zweite Legierungsschicht (3), deren zwei Hauptbestandteile Mangan und Zink sind,
und
- eine die zweite Legierungsschicht kontaktierende äußere Schicht (4) umfassend Manganoxid,
umfasst und wobei
der Anteil der Gesamtmasse an Mangan in der Korrosionsschutzbeschichtung (2,3,4) an der Gesamtmasse an Mangan und Zink in der Korrosionsschutzbeschichtung (2,3,4) größer ist als 25 % und kleiner 40 % ist.

2. Gehärtetes Bauteil nach Anspruch 1, wobei die Dicke der ersten Legierungsschicht (2) größer oder gleich der Dicke der zweiten Legierungsschicht (3) ist.

3. Gehärtetes Bauteil nach einem der vorangehenden Ansprüche, wobei die Dicke der ersten Legierungsschicht (2) größer oder gleich der Gesamtdicke der zweiten Legierungsschicht (3) und der äußeren Schicht (4) ist.

4. Gehärtetes Bauteil nach einem der vorangehenden Ansprüche, wobei
- der Anteil der Gesamtmasse an Mangan in der Korrosionsschutzbeschichtung (2,3,4) an der Gesamtmasse an Mangan und Zink in der Korrosionsschutzbeschichtung (2,3,4)
größer oder gleich 27% ist, bevorzugt größer oder gleich 30% ist,
und/oder
kleiner 35 % ist,
und/oder
im Bereich von größer als 25 % bis 40 % liegt, bevorzugt im Bereich von größer als 25 % bis 35 %, besonders bevorzugt im Bereich von 27% bis 35%,
und/oder
- in der zweiten Legierungsschicht (3), deren zwei Hauptbestandteile Mangan und Zink sind, Eisen in einer Menge bis zu 20 Gew.-% enthalten ist, bezogen auf die zweite Legierungsschicht.

5. Gehärtetes Bauteil nach einem der vorangehenden Ansprüche, wobei die zweite Legierungsschicht (3) bei einer Temperatur von 880 °C zumindest zu 70 Vol.-%, bevorzugt zumindest zu 80 Vol.-% im festen Aggregatszustand vorliegt.

6. Gehärtetes Bauteil nach einem der vorangehenden Ansprüche, wobei das Stahlsubstrat ein Mangan-Bor-Stahl ist.

7. Gehärtetes Bauteil nach einem der vorangehenden Ansprüche, wobei das Stahlsubstrat ein Stahl mit martensitischem Gefüge, vorzugsweise ein Mangan-Bor-Stahl mit martensitischem Gefüge ist.

8. Gehärtetes Bauteil nach einem der vorangehenden Ansprüche, wobei das gehärtete Bauteil ein pressgehärtetes Bauteil ist, vorzugsweise ein Bauteil eines Kraftfahrzeugs, bevorzugt ausgewählt aus der Gruppe bestehend aus Stoßfängerquerträger, Seitenaufprallträger, Säulen und Karosserieverstärkungen.

9. Verfahren zum Herstellen eines gehärteten Bauteils nach einem der Ansprüche 1 bis 8, mit folgenden Schritten:
- Herstellen oder Bereitstellen eines Stahlsubstrats (1),
- Applizieren einer ein- oder mehrlagigen metallischen Schicht (5), deren zwei Hauptbestandteile Zink und Mangan sind, auf das Stahlsubstrat (1), wobei in der ein- oder mehrlagigen metallischen Schicht (5) der Anteil der Gesamtmasse an Mangan an der Gesamtmasse an Mangan und Zink größer ist als 25 % und kleiner 40 % ist, so dass ein Bauteil resultiert,
- Behandeln des hergestellten Bauteils mit der ein- oder mehrlagigen metallischen Schicht, so dass das gehärtete Bauteil resultiert,
wobei das gehärtete Bauteil ein Stahlsubstrat (1) und eine Korrosionsschutzbeschichtung (2,3,4) umfasst, wobei die Korrosionsschutzbeschichtung (2,3,4)
- eine das Stahlsubstrat (1) kontaktierende erste Legierungsschicht (2), deren zwei Hauptbestandteile Eisen und Zink sind
und
- eine die erste Legierungsschicht (2) kontaktierende zweite Legierungsschicht (3), deren zwei Hauptbestandteile Mangan und Zink sind,
und
- eine die zweite Schicht kontaktierende Schicht (4) umfassend Manganoxid umfasst, wobei der Anteil der Gesamtmasse an Mangan in der Korrosionsschutzbeschichtung (2,3,4) an der Gesamtmasse an Mangan und Zink in der Korrosionsschutzbeschichtung (2,3,4) größer ist als 25 % und kleiner ist als 40%,
und
wobei das hergestellte Bauteil als Stahlsubstrat (1) einen Stahl ferritisch-perlitischem Gefüge umfasst, vorzugsweise einen Mangan-Bor-Stahl mit ferritisch-perlitischem Gefüge, und das Behandeln eine thermische Härtungsbehandlung umfasst, bei der das Gefüge in ein martensitisches Gefüge umgewandelt wird.

## Claims

1. Hardened component comprising a steel substrate (1) and an anti-corrosion coating (2, 3, 4), wherein the anti-corrosion coating (2, 3, 4) comprises
- a first alloy layer (2) which contacts the steel substrate and whose two main constituents are iron and zinc,
- a second alloy layer (3) which contacts the first alloy layer (2) and whose two main constituents are manganese and zinc,
and
- an outer layer (4) contacting the second alloy layer and comprising manganese oxide,
and wherein
the fraction of the total mass of manganese in the anti-corrosion coating (2, 3, 4) as a proportion of the total mass of manganese and zinc in the anti-corrosion coating (2, 3, 4) is greater than 25% and less than 40%.

2. Hardened component according to Claim 1, wherein the thickness of the first alloy layer (2) is greater than or equal to the thickness of the second alloy layer (3).

3. Hardened component according to either of the preceding claims, wherein the thickness of the first alloy layer (2) is greater than or equal to the total thickness of the second alloy layer (3) and of the outer layer (4).

4. Hardened component according to any of the preceding claims, wherein
- the fraction of the total mass of manganese in the anti-corrosion coating (2, 3, 4) as a proportion of the total mass of manganese and zinc in the anti-corrosion coating (2, 3, 4)
is greater than or equal to 27%, preferably greater than or equal to 30%,
and/or
is less than 35%,
and/or
is in the range from greater than 25% to 40%, preferably in the range from greater than 25% to 35%, more preferably in the range from 27% to 35%,
and/or
- in the second alloy layer (3), whose two main constituents are manganese and zinc, iron is present in an amount of up to 20 wt%, based on the second alloy layer.

5. Hardened component according to any of the preceding claims, wherein the second alloy layer (3) is in the solid state to an extent of at least 70 vol%, preferably at least 80 vol%, at a temperature of 880°C.

6. Hardened component according to any of the preceding claims, wherein the steel substrate is a manganese-boron steel.

7. Hardened component according to any of the preceding claims, wherein the steel substrate is a steel of martensitic structure, preferably a manganese-boron steel of martensitic structure.

8. Hardened component according to any of the preceding claims, wherein the hardened component is a press-hardened component, preferably a component of a motor vehicle, more preferably selected from the group consisting of bumper cross-beam, side impact beam, columns and bodywork reinforcements.

9. Method for producing a hardened component according to any of Claims 1 to 8, comprising the following steps:
- producing or providing a steel substrate (1),
- applying a single-ply or multi-ply metallic layer (5) whose two main constituents are zinc and manganese to the steel substrate (1), wherein the fraction of the total mass of manganese as a proportion of the total mass of manganese and zinc in the single-ply or multi-ply metallic layer (5) is greater than 25% and less than 40%, to give a component,
- treating the component produced with the single-ply or multi-ply metallic layer, to give the hardened component,
wherein the hardened component comprises a steel substrate (1) and an anti-corrosion coating (2, 3, 4), wherein the anti-corrosion coating (2, 3, 4) comprises
- a first alloy layer (2) which contacts the steel substrate (1) and whose two main constituents are iron and zinc
and
- a second alloy layer (3) which contacts the first alloy layer (2) and whose two main constituents are manganese and zinc,
and
- a layer (4) which contacts the second layer and comprises manganese oxide, wherein the fraction of the total mass of manganese in the anti-corrosion coating (2, 3, 4) as a proportion of the total mass of manganese and zinc in the anti-corrosion coating (2, 3, 4) is greater than 25% and less than 40%,
and
wherein the component produced comprises as steel substrate (1) a steel of ferritic-pearlitic structure, preferably a manganese-boron steel of ferritic-pearlitic structure, and the treating comprises a thermal hardening treatment in which the structure is converted into a martensitic structure.

## Revendications

1. Composant durci, comprenant un substrat en acier (1) et un revêtement anticorrosion (2, 3, 4), le revêtement anticorrosion (2, 3, 4) comprenant
- une première couche d'alliage (2) en contact avec le substrat en acier, dont les deux constituants principaux sont le fer et le zinc,
- une deuxième couche d'alliage (3) en contact avec la première couche d'alliage (2), dont les deux constituants principaux sont le manganèse et le zinc,
et
- une couche extérieure (4) en contact avec la deuxième couche d'alliage, comprenant de l'oxyde de manganèse,
et
la proportion de la masse totale de manganèse dans le revêtement anticorrosion (2, 3, 4) par rapport à la masse totale de manganèse et de zinc dans le revêtement anticorrosion (2, 3, 4) étant supérieure à 25 % et inférieure à 40 %.

2. Composant durci selon la revendication 1, l'épaisseur de la première couche d'alliage (2) étant supérieure ou égale à l'épaisseur de la deuxième couche d'alliage (3).

3. Composant durci selon l'une quelconque des revendications précédentes, l'épaisseur de la première couche d'alliage (2) étant supérieure ou égale à l'épaisseur totale de la deuxième couche d'alliage (3) et de la couche extérieure (4).

4. Composant durci selon l'une quelconque des revendications précédentes,
- la proportion de la masse totale de manganèse dans le revêtement anticorrosion (2, 3, 4) par rapport à la masse totale de manganèse et de zinc dans le revêtement anticorrosion (2, 3, 4)
étant supérieure ou égale à 27 %, de préférence supérieure ou égale à 30 %,
et/ou
étant inférieure à 35 %,
et/ou
se situant dans la plage allant de plus de 25 % à 40 %, de préférence dans la plage allant de plus de 25 % à 35 %, de manière particulièrement préférée dans la plage allant de 27 % à 35 %,
et/ou
- dans la deuxième couche d'alliage (3), dont les deux constituants principaux sont le manganèse et le zinc, du fer est contenu en une quantité allant jusqu'à 20 % en poids, par rapport à la deuxième couche d'alliage.

5. Composant durci selon l'une quelconque des revendications précédentes, la deuxième couche d'alliage (3) se présentant à l'état d'agrégat solide à une température de 880 °C au moins à hauteur de 70 % en volume, de préférence au moins à hauteur de 80 % en volume.

6. Composant durci selon l'une quelconque des revendications précédentes, le substrat en acier étant un acier au manganèse et au bore.

7. Composant durci selon l'une quelconque des revendications précédentes, le substrat en acier étant un acier à structure martensitique, de préférence un acier au manganèse et au bore à structure martensitique.

8. Composant durci selon l'une quelconque des revendications précédentes, le composant durci étant un composant durci sous pression, de préférence un composant d'un véhicule automobile, de préférence choisi dans le groupe constitué par les supports transversaux de pare-chocs, les supports contre les chocs latéraux, les montants et les renforts de carrosserie.

9. Procédé de fabrication d'un composant durci selon l'une quelconque des revendications 1 à 8, comprenant les étapes suivantes :
- la fabrication ou la fourniture d'un substrat en acier (1),
- l'application sur le substrat en acier (1) d'une couche métallique mono- ou multicouche (5), dont les deux constituants principaux sont le zinc et le manganèse, la proportion de la masse totale de manganèse par rapport à la masse totale de manganèse et de zinc dans la couche métallique mono- ou multicouche (5) étant supérieure à 25 % et inférieure à 40 %, de telle sorte qu'il en résulte un composant,
- le traitement du composant fabriqué avec la couche métallique mono- ou multicouche, de telle sorte qu'il en résulte le composant durci, le composant durci comprenant un substrat en acier (1) et un revêtement anticorrosion (2, 3, 4), le revêtement anticorrosion (2, 3, 4) comprenant
- une première couche d'alliage (2) en contact avec le substrat en acier (1), dont les deux constituants principaux sont le fer et le zinc,
et
- une deuxième couche d'alliage (3) en contact avec la première couche d'alliage (2), dont les deux constituants principaux sont le manganèse et le zinc,
et
- une couche (4) en contact avec la deuxième couche, comprenant de l'oxyde de manganèse, la proportion de la masse totale de manganèse dans le revêtement anticorrosion (2, 3, 4) par rapport à la masse totale de manganèse et de zinc dans le revêtement anticorrosion (2, 3, 4) étant supérieure à 25 % et inférieure à 40 %,
et
le composant fabriqué comprenant en tant que substrat en acier (1) un acier à structure ferritique-perlitique, de préférence un acier au manganèse et au bore à structure ferritique-perlitique, et le traitement comprenant un traitement de durcissement thermique dans lequel la structure est transformée en une structure martensitique.
